# EUROPEAN PATENT APPLICATION

(11) **EP 3 279 537 A1**
(43) Date of publication of application: **07.02.2018**
(21) Application number: 16182728.2
(22) Date of filing: 04.08.2016
(51) Int. Cl.: F16L 5/10, F16L 5/02, H05K 3/00, C25D 17/00

(54) **FLEXIBLE SEALING ELEMENT**

(71) Applicant: Atotech Deutschland GmbH, 10553 Berlin (DE)
(72) Inventor: Weinhold, Ray, 10553 Berlin (DE); Scheuerer, Michael, 10553 Berlin (DE); Rauenbusch, Ralph, 10553 Berlin (DE)

(57) **Abstract**

The present invention refers to a sealing element (1) containing several fastening elements (8, 10) and at least one structural weakness (9, 12) to provide a flexible and reversible connection of a second device element (6) containing a pipe (7) and a first device element (4) containing an opening (5). Furthermore, the present invention refers to methods of connecting such first device element and second device element and uses of such sealing element. Additionally the present invention refers to modules and treatment devices containing such sealing element.

## Description

### Field of the Invention

The present invention refers to a sealing element compensating for, for example, a deviation of the orientation or arrangement of elements of, for example, a treatment device for electrolytic or wet chemical treatment. Furthermore, the present invention refers to a method of connecting elements that might provide small deviation in orientation or arrangement. Furthermore, the present invention refers to the use of a sealing element to reversibly connect elements of a device.

### Background of the Invention

Sealing elements are commonly known in the art. They represent essential element of devices and prevent leakage of especially fluids and gases. Herein, the sealing elements provide a form-fit connection between different elements of 1 or more devices and enable the fluid and/or gas exchange. Although, a plurality of different sealing elements are known there are still demands for further improvements to provide sealing elements for specific needs.

For example, it would be helpful to provide sealing elements providing additional functions like correcting a minor incorrect placement of elements of devices during assembly or during use. Such additional function would be very helpful, as, for example, maintenance intervals can be prolonged based on the automatic compensation of minor deviations resulting from operating a device and wear of a moving apparatus contained therein.

### Objective of the present Invention

Thus, it is an objective of the present invention to provide a new type of sealing element to securely seal the connection between two elements of a device while simultaneously providing a possibility to compensate for, for example, a minor incorrect placement of one element of the device to the other or production fluctuations. Herein, it is further required to provide a plug and use possibility while simultaneously providing a secure sealing of the connection even after many uses.

### Summary of the Invention

The aforementioned problems are solved by the inventions as disclosed in the independent and dependent claims and the description. Further objects and additional benefits are included in the following description, however, even further objects not being explicitly stated herein but being immediately derivable or discernible from the connections discussed herein are solved by the present invention and its embodiments representing preferred variations of the invention disclosed herein.

The present invention refers to a sealing element containing a sheath and a mounting base adapted to connect a first device element containing an opening and a second device element containing a pipe, wherein the orientation of the mounting base is essentially perpendicular to the sheath, wherein the sheath contains at least one fastening element on its inside, wherein the mounting base contains at least one fastening element, and wherein the sheath contains on its inside, its outside or both at least one structural weakness located between the at least one fastening element of the sheath and a connection point of the sheath and the mounting base, the mounting base contains at least one structural weakness between the at least one fastening element of the mounting base and the connection point of the sheath and the mounting base, or both.

The phrase "mounting base is essentially perpendicular to the sheath" according to the present invention refers to an orientation of the mounting base, wherein the mounting base is oriented essentially perpendicular to the axis of the sheath at the connection point of the sheath and the mounting base. Especially, it is preferred that the angle between a line parallel to the axis of the sheath and the center line of the mounting base at the connection point of the sheath and the mounting base in a cross section along the axis of the sheath is selected from the range from 70° to 110°, more preferred from 80° to 100°.

The phrase "the sheath contains on its inside, its outside or both at least one structural weakness located between the at least one fastening element of the sheath and a connection point of the sheath and the mounting base, the mounting base contains at least one structural weakness between the at least one fastening element of the mounting base and the connection point of the sheath and the mounting base, or both" as used herein means that the sheath contains on its inside, its outside or both at least one structural weakness located between the at least one fastening element of the sheath and a connection point of the sheath and the mounting base, or that the mounting base contains at least one structural weakness between the at least one fastening element of the mounting base and the connection point of the sheath and the mounting base, or that the corresponding part of the sheath and the corresponding part of the mounting base each contains at least one structural weakness.

Definitions included in the present application like the aforementioned referring to the "mounting base is essentially perpendicular to the sheath" refer to the whole application unless such term is explicitly specified otherwise at a different location.

The term "axis" of the sheath refers to the line going through the centers of the passage through the sheath adapted to contact the pipe of the second device element disregarding the structural weaknesses and fastening elements. The phrase "center of the passage" refers to the center of the passage in a cross section perpendicular to the movement direction of a pipe introduced into said passage. If said passage is formed irregularly resulting in no straight line by connecting said centers the axis is based on the linear regression line through the centers of said passage in the core area adapted to contact the substrate using, for example, at least 10, like 10, more preferred at least 30, like 30, centers randomly selected in the core area. The phrase "core area of the passage" according to the present invention refers to the 70 % of the passage located in the middle of the passage adapted to contact the pipe of the second device element.

Furthermore, the present invention refers to a module containing a first device element and an inventive sealing element, wherein the mounting base of the sealing element is firmly attached to the first device element by means of the at least one fastening element of the mounting base.

Furthermore, the present invention refers to a device containing a first device element containing at least one opening, a second device element containing at least one pipe and at least one inventive sealing element, wherein the mounting base of the at least one sealing element is firmly attached in the at least one opening of the first device element by means of the at least one fastening element of the mounting base, and wherein the at least one pipe of the second device element is adapted to be reversibly fastened to the sealing element firmly attached in an opening of the first device element by means of the at least one fastening element of the sheath of the sealing element.

The phrase "reversibly fastened" according to the present invention refers to temporary fastening being easily released. An example of such fastenings is a plug and use fastening allowing a device element being simply pressed against another device element to establish a connection between said device elements to enable, for example, a fluid or gas exchange. For example, a corresponding module is simply attached by pressing it against the connective element of the corresponding counterpart and released by pulling the module away from the connective element.

Furthermore, the present invention refers to a kit containing a first device element providing at least one inventive sealing element firmly attached in an opening of the first device element and containing a second device element providing at least one pipe adapted to be fastened to at least one fastening element of the sheath of the inventive sealing element.

Furthermore, the present invention refers to a method to reversibly and flexibly connect a first device element containing at least one opening and a second device element containing at least one pipe, wherein first a) the at least one inventive sealing element is firmly attached to the first device element by means of the at least one fastening element of the mounting base, and then b) the at least one pipe of the second device element is reversibly fastened to the at least one fastening element of the sheath of the sealing element.

Furthermore, the present invention refers to an use of the inventive sealing element to provide a plug-and-use arrangement of a first device element containing at least one opening and a second device element containing at least one pipe, wherein the at least one sealing element is firmly attached to the at least one opening of the first device element by means of the at least one fastening element of the mounting base to provide at least one fastening element to reversible fasten at least one pipe of a second device element to the at least one fastening element of the sheath of the sealing element.

### Brief Description of the Figures

For a more complete understanding of the present invention, reference is made to the following Detailed Description of the Invention considered in conjunction with the accompanying figures, in which:
Figure 1 shows a schematic cross section of an example of the inventive sealing element.
Figure 2 shows a schematic side view of an inventive sealing element similar to the one shown in Figure 1 perpendicular to the axis of the sheath.
Figure 3 shows a schematic side view of an inventive sealing element as shown in Figure 1 along the axis of the sheath.
Figure 4 shows a schematic top view of an inventive sealing element as shown in Figure 1 along the axis of the sheath. Herein, the form of the basic shape of the mounting base differs from Figure 3.
Figures 5 to 8 show schematic cross sections of alternative examples of the inventive sealing element.
Figure 9 shows a schematic cross section of an example of the inventive sealing element, wherein the pipe of the second device element is introduced into the sheath.
Figures 10 to 11 show schematic cross sections of alternative examples of the inventive sealing element.
Figures 12 and 13 show schematic cross sections of examples of the inventive sealing element and a part of the second device element.
Figure 14 shows a schematic cross section of an example of the inventive sealing element, a part of the pipe of the second device element and a part of the first device element.
Figure 15 shows a schematic drawing of an example of the inventive module being introduced into a treatment device containing the second device element providing the pipe to be connected to the module.

### Detailed Description of the Invention

The present invention refers to a sealing element containing a sheath and a mounting base adapted to connect a first device element containing an opening and a second device element containing a pipe, wherein the orientation of the mounting base is essentially perpendicular to the sheath, wherein the sheath contains at least one fastening element on its inside, wherein the mounting base contains at least one fastening element, and wherein the sheath contains on its inside, its outside or both at least one structural weakness located between the at least one fastening element of the sheath and a connection point of the sheath and the mounting base, the mounting base contains at least one structural weakness between the at least one fastening element of the mounting base and the connection point of the sheath and the mounting base, or both.

According to further embodiments of the present invention the at least one fastening element of the mounting base is a bulge of the mounting base. Such kind of fastening element is simple to manufacture and provided a very efficient fastening of the mounting base to the first device element. Furthermore, if the bulge is a continuous circle such fastening element further provides an additional sealing element if clamped between two parts of the first device element. Typically, it is preferred that, for example, the shape and the material of the bulge of the mounting are selected to enable the bulge to function as squeeze type seal.

In further embodiments of the present invention the at least one fastening element of the sheath is a bulge on the inside of the sheath. Also in this case a continuous circle surrounding the passage of the sheath proved to be especially useful, as such fastening element provided additional sealing properties. According to further embodiments of the present invention the at least one fastening element on the inside of the sheath extends around the opening of the sheath. The phrase "extends around the opening of the sheath" according to the present invention refers to a shape, wherein the corresponding element extends around the passage through the sheath like a circular line being a bulge of the inside of the sheath in case of a cylindrical passage with circular base.

However, the fastening elements of the present invention can also be selected from other fastening elements known to the person skilled in the art. For example, the at least one fastening element of the sheath, the mounting base or both can be a magnetic element like a neodymium magnet preferably located on the inside of the material of the sealing element. Herein, said magnetic element is drawn to a corresponding ferromagnetic element located at the pipe of the second device element. Naturally, said combination could also be vice versa placing a magnetic element at the pipe and a ferromagnetic element at the sealing element. Also combinations of different types of corresponding fastening elements can be used.

According to further embodiments of the present invention the at least one structural weakness of the sheath is an indentation or an expansion joint, more preferred an indentation. Especially, using an indentation proved to be very beneficial for many embodiments, as it provided flexibility to the movement of the sheath without allowing the sheath to stretch away from the pipe. However, for specific embodiments both kinds of structural weaknesses were essential equal or the expansion joint even provided better results. Such specific case was, for example, a sealing element, wherein the side adapted to insert the pipe contained the expansion joint and a broadened opening.

In further embodiments of the present invention the sheath provides at least one structural weakness being an expansion joint on the entry side of the mounting base, if at least one fastening element of the sheath adapted to fasten the pipe of the second device element is located between the entry opening of the sheath and the expansion joint on the entry side of the sheath.

The phrase "on the entry side of the mounting base" according to the present invention refers to the side of the mounting base being adapted to be directed towards the pipe entering the sheath.

According to further embodiments of the present invention the sheath provides no expansion joint on the exit side of the mounting base, if at least one fastening element of the sheath adapted to fasten the pipe of the second device element is located behind the expansion joint on the exit side of the mounting base.

The phrase "exit side of the mounting base" according to the present invention refers to the side of the mounting base being opposite to the entry side.

In further embodiments of the present invention the sheath provides at least one structural weakness being an indentation, wherein the at least one indentation is arranged between the connection point of the sheath and the mounting base and the at least one fastening element of the sheath adapted to fasten the pipe of the second device element, and wherein said indentation provides a minimal thickness of the sidewall being selected from the range from 0.2 to 0.7, more preferred from 0.25 to 0.63, even more preferred from 0.27 to 0.59, of the average thickness of the sheath next to the indentation.

Unless specified otherwise an "average" value as used herein refers to the arithmetic mean of said value calculated based on the sum of a certain number of values divided by their number (average value = sum of measured values / number of measured values). To achieve a statistical significant value at least a certain number of values have to be used for calculating said value, for example, at least 10, for example 10, values. The number of measurements, however, can be increased, for example, to at least 50, for example 50, or at least 100, for example 100, if the fluctuation of the values is high.

The phrase "connection point of the sheath and the mounting base" according to the present invention refers to the point, where the sheath and the mounting base come into contact with each other. If there are multiple connection points available the nearest connection point is used for measurements.

The term "minimal thickness of the sheath at the indentation" refers to the lowest thickness of the sidewall of the sheath within the area of the indentation of the sheath in a cross section along the axis of the sheath.

According to further embodiments of the present invention the sheath contains at most 2 structural weaknesses, more preferred 1 structural weakness, on the side of the mounting base containing at least one fastening element adapted to fasten the pipe of the second device element. It was noted that 1 structural weakness is often enough to provide the required flexibility for the inventive sealing element, while reducing the amount of work required to produce said sealing element.

In further embodiments of the present invention the mounting base contains at least one structural weakness. Examples of such weaknesses are indentations and expansion joints. Preferably, at least one of the structural weaknesses of the mounting base is an indentation. According to further embodiments it is especially preferred that the minimal thickness of the mounting base at the indentation lies within the range from 0.15 to 0.9, more preferred from 0.18 to 0.75, even more preferred from 0.22 to 0.65, of the average thickness of the mounting base next to the indentation. Such structural weakness additionally increases the flexibility of the sheath for specific embodiments.

The term "minimal thickness of the mounting base at the indentation" refers to the lowest thickness of the mounting base within the area of the indentation of the mounting base in a cross section along the axis of the sheath.

Typically, it is preferred that the structural weakness of the sheath, the mounting base or both being an indentation takes the shape of a continuous channel. For example, it can take the form of an angular like polyangular, circular, elliptical or oval shaped channel on the surface of the sheath going around the sheath. Naturally, the final shape of the channel also depends on the form of the surface of the sheath. It was noted that the indentations of the sheath and the mounting base preferably provide an essentially rotational symmetry around the axis of the sheath in case of a circular sheath or a corresponding symmetry based on the provided shape of the sheath. The phrase "essentially rotational symmetry" according to the present invention means that the real indentation does not diverge greatly from the ideal rotational symmetry. Preferably, it does not diverge more than 5 mm, more preferred not more than 3 mm, even more preferred not more than 1 mm, from an ideal rotational symmetric indentation. The term "continuous channel" according to the present invention preferably refers to a channel circling the passage of the sheath at least once, preferably once, and connecting to itself thereafter.

If the structural weakness of the sheath is an indentation, it is possible to place such indentation on the inside, the outside or both. Typically, it is preferred to place said indentation on the outside of the sheath. It appears that such placement of the indentations provide an increased flexibility of the sheath for many or even most embodiments.

According to further embodiments of the present invention the sheath, the mounting base or both contain at least one structural weakness next to the connection point of the sheath and the mounting base. Preferably, said at least one structural weakness starts at most 0.4 mm, more preferred at most 0.1 mm, distant from the connection point of the sheath and the mounting base. Especially, it is preferred that it starts right at the connection point of the sheath and the mounting base. It was noted that such structural weaknesses typically provided an increased flexibility of the sheath of the sealing element for many embodiments.

According to further embodiments of the present invention sealing element contains at least one material selected from the group of organic polymers, more preferred elastomers, even more preferred rubbers. Examples of organic polymers are NBR (nitrile rubber), HNBR (hydrated nitrile rubber), EPDM (ethylene propylene diene rubber), MVQ (silicone rubber), MFQ (fluor silicone rubber), FKM (fluoroelastomers), ACM (alkyl acrylate copolymer), FFKM (perfluoroelastomers), CR (polyychloroprene), CSM (chlorosulfonated polyethylene synthetic rubber), AU (polyester urethane rubber), IIR (butyl rubber), and NR (natural rubber). Preferably, at least 70 wt.-%, more preferred at least 90 wt.-%, even more preferred 100 wt.-%, of the sealing element are selected from these materials, based on the total weight of the sealing element. For example, for typical aqueous system EPDM being a terpolymer of ethylene, propylene and a diene component proved to be especially useful.

The term "organic polymer" refers to organic polymeric materials as used in the art. Such polymers can be produced by, for example, polymerizing organic monomers or oligomers. Said organic polymer can contain fillers, lubricants, plasticizer and further typical additives known in the art. Such additives are typically used to influence properties of the organic polymer like the durability or resistance against aging to adapt the polymer to specified requirements of the corresponding use.

In further embodiments of the present invention the sheath contains at least one expansion joint, if the material of the corresponding part of the sheath is selected from a rigid material. Examples of such rigid materials are metal or duroplastic plastics. Corresponding sealing elements provided an improved resistance against, for example, certain chemicals.

According to further embodiments of the present invention the sealing element provides an average inner diameter of the sheath of at least 1 cm, more preferred at least 0.1.6 cm, even more preferred at least 2.2 cm. Herein, the average inner diameter is calculated based on the total volume of the passage of the sheath and the length of the center line going through the middle of the passage of the sheath. It was noted that sealing elements providing lower inner diameters typically provided a less pronounced beneficial effect.

According to further embodiments of the present invention the sealing element provides an average thickness of the sidewall of the sheath of at least 0.5 mm, more preferred at least 0.7 mm, even more preferred at least 0.9 mm. Using such inventive sealing elements typically provided an improved stability and lifetime.

The phrase "average thickness of the sidewall of the sheath" according to the present invention refers to the thickness of the sidewall of the sheath excluding fastening elements and structural weaknesses. Preferably, at least 10 measurements, for example 10 measurements, are taken and the arithmetic mean is calculated.

In further embodiments of the present invention the sealing element provides an average thickness of the sidewall of the sheath of at most 9 mm, more preferred at most 3 mm, even more preferred at most 1.5 mm. Said thickness is measured from one surface of the mounting base to the other. Herein, the average thickness of the sidewall is measured excluding fastening elements or structural weaknesses. It was noted that too thick side walls typically provided less or no benefits, however, increased the size of the sealing element.

According to further embodiments of the present invention the sealing element provides an average thickness of the mounting base of at least 0.7 mm, more preferred at least 0.9 mm, even more preferred at least one mm. The phrase "average thickness of the mounting base" according to the present invention refers to the thickness of the mounting base excluding fastening elements and structural weaknesses. The phrase "surface of the mounting base" according to the present invention refers to the surface of the mounting base directed to the entry side of the sheath or directed to the opposite side.

In further embodiments of the present invention the mounting base provides a basic shape being essentially angular like polyangular, circular or elliptical. A preferred type of polyangular shape is the rectangular shape like a square shape. The phrase "basic shape of the mounting base" according to the present invention refers to a shape of the mounting base viewed along the axis of the sheath. For example, the form of basic shape can be visualized by projecting the form of the sealing element onto a plane perpendicular to the axis of the sheath.

According to further embodiments of the present invention the sealing element provides a distance from the axis of the sheath to the end of a surface of the mounting base measured perpendicular to the axis of the sheath of at most 2.5 times, more preferred at most 2.2 times, even more preferred at most 1.9 times, the outer radius of the sheath measured from the axis of the sheath to the connection point of the sheath and the mounting base of the surface of the mounting base. It was noted that the aforementioned relationship of the size of the mounting base to the outer radius of the sheath seem to provide a good balance of structural stability and flexibility for many embodiments.

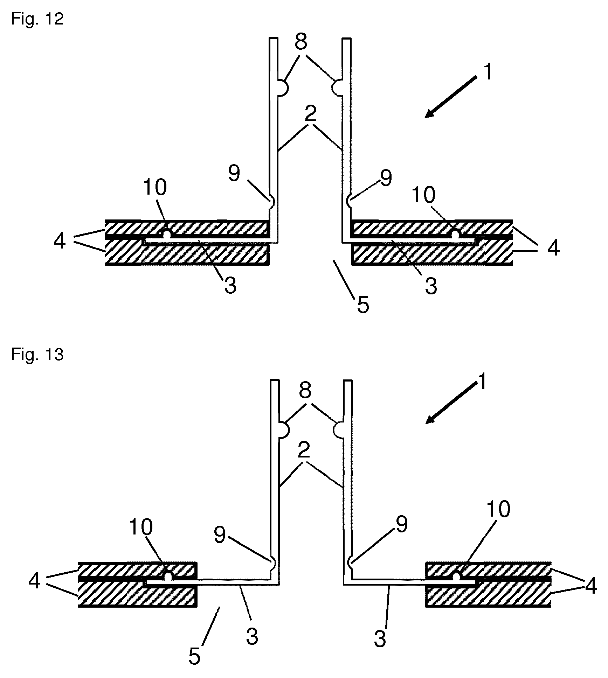

In further embodiments of the present invention the sealing element provides a distance from the axis of the sheath to the end of a surface of the mounting base measured perpendicular to the axis of the sheath of at least 1.3 times, more preferred at least 1.5 times, even more preferred at least 1.6 times, the outer radius of the sheath measured from the axis of the sheath to the connection point of the sheath and the mounting base of the surface of the mounting base. Sealing elements providing a smaller mounting base typically proved to be less effective for certain embodiments like figure 13, wherein the mounting base should also contribute to the flexibility.

According to further embodiments of the present invention the mounting base contains only a single fastening element. It was noted that the sealing and fastening properties typically were sufficient, while the installation is simplified.

In further embodiments of the present invention the at least one fastening element of the mounting base is a squeeze-type fastening element. Such squeeze-type fastening element further provides the benefit that it very effectively seals the opening of the first device element when the sealing element is fixed to the first device element. It was noted that a very effective type of squeeze type seal being easy to produce takes the shape of a bulge of the mounting base.

According to further embodiments of the present invention at least one fastening element of the mounting base, preferably all fastening element of the mounting base, are located on the exit side of the mounting base. It was noted that such sealing element typically provided an improved sealing behaviour.

In further embodiments of the present invention the sheath only contains a single fastening element on its inside. It was noted that using only a single fastening element on the inside of the sheath still provided a reliable fastening of the pipe for typical applications. Simultanously, the production of the sealing element and the pipe of the second device element are greatly simplified.

According to further embodiments of the present invention the sheath contains no fastening elements on the outside of the sheath.

In further embodiments of the present invention the distance between the connection point of the sheath and the mounting base and the first fastening element of the mounting base is at least 0.3 times, more preferred at least 0.4 times, even more preferred at least 0.5 times, the distance between the connection point of the sheath and the mounting base and the first fastening element of the sheath. First fastening element in this context refers to the fastening element providing the lowest distance between the connection point of the sheath and the mounting base and the fastening element either on the mounting base or on the sheath. Such sealing elements typically provided a further increased flexibility of the movement of the sheath. It is assumed that said flexibility results from a stretching and compressing of the mounting base.

According to further embodiments of the present invention the distance between the connection point of the sheath and the mounting base and the first fastening element of the mounting base is at most 2 times, more preferred at most 1.8 times, even more preferred at most 1.6 times, the distance between the connection point of the sheath and the mounting base and the first fastening element of the sheath. It was noted that such sealing elements typically provided an improved balance of the flexibility of the movement of the sheath and the long term stability of the orientation of the sheath. It is assumed that, for example, the improved long term stability results from the smaller amount of the mounting base surface enclosed between the sheath and the nearest fastening element of the mounting base. Said part of the mounting base seems to be especially prone to wear effects resulting from long term usage and a loss of elasticity can result in an increasing misplacement of the sheath. Such increasing misplacement can result in damages of the sealing element during insertion of the pipe of the second device element.

In further embodiments of the present invention the inner diameter of the sheath is at least 20 mm, more preferred at least 24 mm, even more preferred at least 26 mm, based on the thinnest inner diameter of the sheath adapted to contact the pipe of the second device element. Herein, the inner diameter of the sheath is measured perpendicular to the center line of the sheath going through the middle of the passage of the sheath.

According to further embodiments of the present invention the inner diameter of the sheath is at most 100 mm, more preferred at most 85 mm, even more preferred at most 65 mm, based on the thinnest inner diameter of the sheath adapted to contact the pipe of the second device element.

In further embodiments of the present invention the sheath provides a passage containing at least one narrow point behind a fastening element adapted to fasten the pipe of the second device element. The term "behind" according to the present invention is based on the insert direction of the pipe. The term "narrow point" according to the present invention refers to a part of the passage of the sheath providing a reduction of the size of the passage through the sheath. This can be, for example, achieved by reducing the diameter of the inner passage or provide a change of the shape of the inner passage. For example, it can be preferred that the perimeter of the thinnest part in the passage adapted to contact the pipe of the second device element of the sheath is at least 3 %, more preferred at least 5 %, even more preferred at least 6 %, smaller than the perimeter of the widest part of the passage adapted to contact the pipe of the second device element. The phrases "thinnest part in the passage of the sheath" and "widest part of the passage of the sheath" according to the present invention refer to the thinnest and widest part of the passage of the sheath excluding fastening elements and structural weaknesses. It was noted that corresponding sealing elements typically provided a more simplified correct attachment of the first device element to the pipe of the second device element.

According to further embodiments of the present invention the sealing element is adapted to provide an exit side of the mounting base, and wherein the sheath provides a passage containing at least one narrow point at the exit side of the mounting base. It appears that for many applications the stability of the connection of the pipe of the second device element and the sealing element is increased by a greater contact area of the pipe and the passage of the sealing element. To provide a very compact overall design of the first and second device element it is, thus preferred to use as much of the contact surface of the passage as possible and place the narrow point on the exit side of the mounting base. In further specific of these embodiments it is preferred that the passage of the sheath provides no narrow point providing a perimeter of the thinnest part in the passage adapted to contact the pipe of the second device element of the sheath of at least 5 %, more preferred at least 3 %, smaller than the perimeter of the widest part of the passage adapted to contact the pipe of the second device element.

In further embodiments of the present invention the inside of the sheath provides a non-uniform diameter in the part adapted to contact the pipe of the second device element besides the at least one fastening element and the at least one structural weakness. Such non-uniform diameter can, for example, result from a non-uniform thickness of the sidewall of the sheath or a curvature or inclination of the sidewall of the sheath. It proved to be especially useful for many embodiments to provide a sheath containing at least one curvature or inclination in the area adapted to contact the pipe of the second device element, wherein an inclination appeared to be especially useful. Preferably, the aforementioned non-uniform diameter results in a narrowing of the passage of the sheath adapted to contact the pipe of the second device element behind the fastening element, based on the diameter of the passage excluding fastening elements and structural weaknesses.

According to further embodiments of the present invention the inside of the sheath provides at least one element, more preferred at least two elements, selected from the group consisting of curvatures, inclinations or combinations thereof, based upon a cross section along the axis of the sheath and disregarding the at least one fastening element and the at least one structural weakness.

In further embodiments of the present invention the sheath provides a length above the mounting base measured along the axis of the sheath being longer than the longest length of the mounting base measured from the connection point of the sheath and the mounting base radially outwards along the surface of the mounting base. The term "radially" according to the present invention refers to lines providing a straight line directed on the axis of the sheath when being projected along lines parallel to the axis of the sheath onto a plane perpendicular to the axis of the sheath.

According to further embodiments of the present invention the at least one fastening element of the mounting base is located on the exit side of the mounting base. Such sealing elements typically proved to be especially useful for, for example, modules, wherein the greater part of the sheath is located inside the module. Corresponding devices typically seem to provide an increased strength of the sealing even under extreme conditions.

In further embodiments of the present invention the mounting base provides at least two fastening elements adapted to fasten the sealing element to the first device element, and wherein at least one of said fastening elements is located on the entry side and at least one of said fastening elements is located on the exit side of the mounting base. Such sealing elements require an increased precision while tooling the sealing element and the corresponding parts of the first device element, however, typically seem to provide a further increased sealing strength.

According to further embodiments of the present invention the sheath provides a sidewall providing an average thickness being selected from the range from 0.02 times to 0.2 times, more preferred from 0.04 times to 0,16 times, even more preferred from 0.05 times to 0.12 times, of the average inner radius of the sheath. It appears that corresponding sealing elements provide a further improved balance of stability and flexibility.

In further embodiments of the present invention the sheath extends towards the entry side, the exit side or both beyond the mounting base. Preferably, the sheath extends towards the exit side beyond the mounting base.

According to further embodiments of the present invention the sheath only extends towards 1 side beyond the mounting base, more preferred only towards the exit side beyond the mounting base.

In further embodiments of the present invention the mounting base provides a surface, wherein the angle between the sheath and the surface of the mounting base at the connection point of the sheath and the mounting base is essentially perpendicular, unless the connection point is part of a structural weakness or a fastening element of the sheath located on the outside of the sheath or of a structural weakness or a fastening element of the mounting base. For example, it can be selected from the range from 80° to 100°, more preferred from 85° to 95°.

According to further embodiments of the present invention the greater part, preferably at least 55 %, more preferred at least 70 %, even more preferred at least 90 %, of the sheath extends towards one side, preferably the exit side, of the mounting base, based on the length of the sheath in relation to the total length of the sheath. Herein, the corresponding part of the sheath is measured starting from the connection point of the sheath and the mounting base.

In further embodiments of the present invention the inside of the sheath adapted to contact the pipe of the second device element provides the shape of an essentially round tube, more preferred of a round tube, disregarding fastening elements and structural weaknesses. Such sealing elements proved to be typically beneficial as, for example, the angle of orientation to each other of the first device element and the second device element can be disregarded. Herein, such shape of a round tube does not exclude that, for example, the part of the sheath adapted to contact the pipe of the second device element provides at least one narrowing and/or at least one broadening of the tube, wherein said part, however, preferably provides a uniform decreasing or increasing of the form of the passage resulting in a change of the size of the diameter without changing the general shape of the passage. For example, a passage being circular preferably provides a smaller circle as passage at the point of the narrowing.

According to further embodiments of the present invention the at least one fastening element of the sheath adapted to fasten the pipe of the second device element is located on one side of the mounting base, more preferred on the exit side of the mounting base.

According to further embodiments of the present invention at least one fastening element of the sheath adapted to fasten the pipe of the second device element is located in the last 50 %, more preferred the last 30 %, even more preferred the last 20 %, of the sheath adapted to contact the pipe of the second device element, based on the total length of the part of the sheath adapted to contact the pipe of the second device element along the axis of the sheath. Herein, the corresponding part of the axis of the sheath is the greatest part of the axis available when projecting the end points of the inside of the sheath adapted to contact the pipe of the second device element along lines perpendicular to said axis onto said axis. The aforementioned last part of the sheath is based on the direction of entry of the pipe of the second device element.

In further embodiments of the present invention the sealing element is adapted to provide a part of the mounting base not directly being in contact with the first device element. For example, it can be preferred that the distance between the connection point of the sheath and the mounting base and the nearest part of the mounting base coming into contact with the first device element is at least 0.1 times, more preferred at least 0.2 times, even more preferred at least 0.25 times, the outer radius of the sheath measured perpendicular to the axis of the sheath from the axis of the sheath to the connection of the sheath and the mounting base, wherein the distance between the connection of the sheath and the mounting base and the nearest part of the mounting base directly contacting the first device element is measured radially outwards along the surface of the mounting base. It appears that corresponding sealing elements provide an even further improved flexibility of the movement of the sheath to adapt to minor misplacement of the first device element or the second device element.

According to further embodiments of the present invention the mounting base is adapted to provide a part of the mounting base not directly being in contact with the first device element, wherein the distance between the connection of the sheath and the mounting base and the nearest part of the mounting base coming into contact with the first device element is at most 1.3 times, more preferred at most 1.1 times, even more preferred at most 0.9 times, the outer radius of the sheath measured perpendicular to the axis of the sheath from the axis of the sheath to the connection of the sheath and the mounting base, wherein the distance between the connection of the sheath and the mounting base and the nearest part of the mounting base directly contacting the first device element is measured radially outwards along the surface of the mounting base. It was noted that corresponding sealing element typically provided a further improved balance of structural stability and flexibility.

A further aspect the present invention refers to a module containing a first device element and an inventive sealing element, wherein the mounting base of the sealing element is firmly attached to the first device element by means of the at least one fastening element of the mounting base.

The term "module" as used herein refers to a subunit of, for example, a treatment device providing a delimitation from the other parts of said treatment device. Using such modules allows an easy arrangement according to the specific requirements, an easy exchange of the substrate holder to adapt the treatment device to different kinds of substrates, for example, providing different sizes or thicknesses. Also such modules allow to easily upgrade said part of the treatment device for future developments, different uses or additional needs. For example, it can provide certain delimitations like walls and defined openings to neighbouring modules or other parts of the treatment device to enable the flow of a treatment fluid or gas through said module. According to preferred embodiments of the present invention the module contains a substrate holder as well as a treatment chamber for treating the substrate. For example, said module can also contain anodes to enable a galvanic treatment. Such modules can be used for various process steps like galvanic pretreatment, galvanic treatment and rinsing processes. Herein, such process steps can be performed in multiple modules moving a substrate holder from one module to another, multiple process steps can be performed in one module or combinations thereof.

The phrase "firmly attached" according to the present invention refers to typically reversible connection being, however, no plug and use connection. Especially, fastening the sealing element to the first device element typically requires a part of the first device element to the opened or removed. For example, the corresponding part of the first device element can later be fastened again using clips, screws, bolts or glue, preferably clips, screws or bolts as they typically provide a more stable connection in typical environments. Screws and bolts, especially screws proved to be typically especially useful. Herein, it has to be noted that it is sufficient, for example, in case of a mounting base of the sealing element being firmly attached to the first device element by means of the at least one fastening element of the mounting base that only a part of the mounting base is directly in contact with the first device element. However, it is also possible that the whole mounting base is clamped between parts of the first device element.

In further embodiments of the present invention the greater part of the sheath of the sealing element is located in the module. Preferably, at least 80 %, more preferred at least 90 %, even more preferred at least 95 %, of the length of the sheath is located in the inside of the module, based on the total length of the sheath. Herein, the aforementioned relation is based on the length of the sheath starting from the connection point of the sheath and the mounting base on the side directed to the interior of the first device element. Such arrangement makes it possible to provide a secure reversible connection of the sealing element to the pipe of the second device element, while making it possible to realize a very compact construction of the first device element without greater parts extending beyond the general shape of the first device element. This proved to be typically very beneficial, as it further reduced the risk of contacting protruding elements of the sealing element during movement resulting in possible damages and leakages.

According to further embodiments of the present invention at least one inventive sealing element is located in an outlet of the module. It was noted it was very efficient for many embodiments providing a module for treating a substrate with a fluid to locate the outlet at the bottom of the module and to connect said outlet to a pipe of the surrounding device element to remove the used treatment liquid from said module. Using the inventive sealing element provided the possibility to simply move the module to the corresponding device element and plug said pipe into the opening of the module. Such method greatly reduced the required amount of work, while the inventive sealing element provided the required sealing despite the simply procedure.

According to further embodiments of the present invention the first device element is adapted to receive at least a part of the mounting base of the sealing element and to fasten the sealing element by means of at least one fastening element located on the mounting base of the sealing element.

In further embodiments of the present invention the sealing element provides a part of the mounting base not directly being in contact with the first device element. For example, it can be preferred that the distance between the connection point of the sheath and the mounting base and the nearest part of the mounting base coming into contact with the first device element is at least 0.01 times, more preferred at least 0.02 times, even more preferred at least 0.025 times, the outer radius of the sheath measured perpendicular to the axis of the sheath from the axis of the sheath to the connection point of the sheath and the mounting base, wherein the distance between the connection point of the sheath and the mounting base and the nearest part of the mounting base directly contacting the first device element is measured radially outwards along the surface of the mounting base.

According to further embodiments of the present invention the distance between the connection point of the sheath and the mounting base and the nearest part of the mounting base coming into contact with the first device element is at most 0.8 times, more preferred at most 0.6 times, even more preferred at most 0.5 times, the outer radius of the sheath measured perpendicular to the axis of the sheath from the axis of the sheath to the connection point of the sheath and the mounting base, wherein the distance between the connection point of the sheath and the mounting base and the nearest part of the mounting base directly contacting the first device element is measured radially outwards along the surface of the mounting base.

A further aspect of the present invention refers to a device containing a first device element containing at least one opening, a second device element containing at least one pipe and at least one inventive sealing element, wherein the mounting base of the at least one sealing element is firmly attached in the at least one opening of the first device element by means of the at least one fastening element of the mounting base, and wherein the at least one pipe of the second device element is adapted to be reversibly fastened to the sealing element firmly attached in an opening of the first device element by means of the at least one fastening element of the sheath of the sealing element.

In further embodiments of the present invention the device is a device for electrolytic treatment, wet chemical treatment or rinsing, more preferred for electrolytic treatment or wet chemical treatment. Such inventive device can be used for, for example, in the production of a circuit board, a circuit foil, a semiconductor wafer, a solar cell or a photoelectric cell. For example, such device might be used in to deposit copper or other metals on the surface of wafers or circuit boards.

For example, the inventive sealing element as described above can be benefically used to provide a connection between multiple device element located in a device for electrolytic treatment, wet chemical treatment or rinsing used in clean rooms. Herein, it is especially required to provide highly reliable and space-saving devices. Such benefits also render the present sealing elements beneficial for, for example, aircraft and spacecraft technology. Other potential uses are readily available for the person skilled in the art based on the features and/or benefits disclosed herein.

According to further embodiments of the present invention the first device element and the sealing element are part of an inventive module adapted to be reversibly connected to the second device element.

A further aspect of the present invention refers to a kit containing a first device element providing at least one inventive sealing element firmly attached in an opening of the first device element and containing a second device element providing at least one pipe adapted to be fastened to at least one fastening element of the sheath of the inventive sealing element.

A further aspect of the present invention refers to a method to reversibly and flexibly connect a first device element containing at least one opening and a second device element containing at least one pipe, wherein first a) the at least one inventive sealing element is firmly attached to the first device element by means of the at least one fastening element of the mounting base, and then b) the at least one pipe of the second device element is reversibly fastened to the at least one fastening element of the sheath of the sealing element.

According to further embodiments of the present invention the pipe of the second device element is plugged into the sheath of the sealing element.

A further aspect of the present invention refers to an use of the inventive sealing element to provide a plug-and-use arrangement of a first device element containing at least one opening and a second device element containing at least one pipe, wherein the at least one sealing element is firmly attached to the at least one opening of the first device element by means of the at least one fastening element of the mounting base to provide at least one fastening element to reversible fasten at least one pipe of a second device element to the at least one fastening element of the sheath of the sealing element.

The following non-limiting examples are provided to illustrate preferred embodiments of the present invention and to facilitate understanding of the invention, but are not intended to limit the scope of the invention, which is defined by the claims appended hereto.

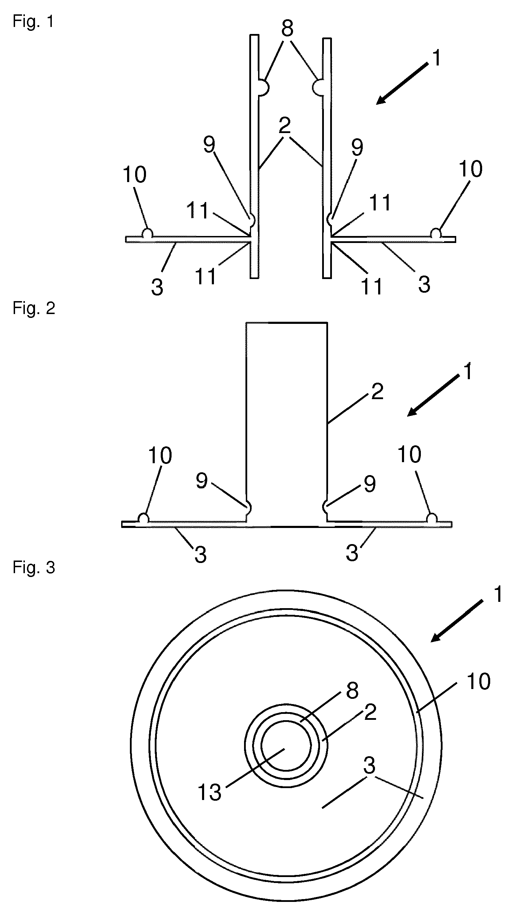

Figure 1 shows a quite simple yet efficient example of the inventive sealing element 1. The figure represents a schematic cross section along the axis of the sheath 2. Herein, the cross section of the sheath 2 shows the structural weakness 9 of the sheath 2 located between the fastening element 8 of the sheath 2 and the connection point 11 of the sheath 2 and the mounting base 3. In this case the structural weakness 9 is an indentation providing a certain flexibility of the sheath 2 to adapt the sealing element 1, for example, to certain production fluctuations resulting from a, for example, slight misplacement of the pipe of the second device element.

The fastening element 8 of the sheath 2 is a bulge adapted to fit into a corresponding part of the pipe of the second device element to fasten the pipe of the second device element temporary to the sealing element 1. Also the fastening element 10 of the mounting base 3 is a bulge located at the end of the mounting base 3 to provide a firm attachment to the corresponding part of the first device element.

The sheath 2 extends beyond the connection point 11 of the sheath 2 and the mounting base 3 without providing further structural weaknesses 9 or fastening elements 8.

Figure 2 shows a schematic side view of an example of an inventive sealing element 1 similar to the one shown in figure 1. Herein, the inside of the sheath 2 is not visible. On the sides of the sheath 2 the structural weakness 9 is clearly available being also an indentation as shown in figure 1. Furthermore, the figure shows the fastening element 10 of the mounting base 3 being located at the end of the mounting base 3.

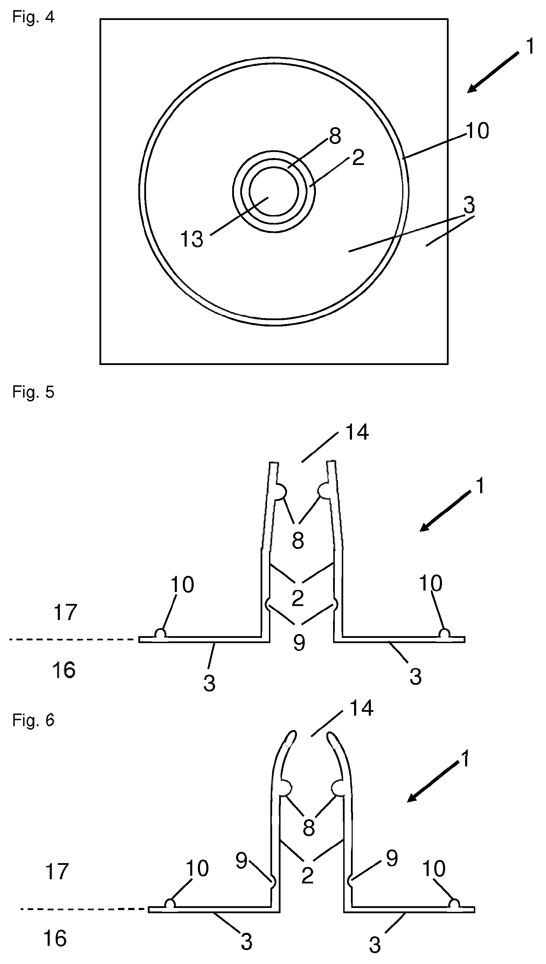

Figures 3 and 4 show schematic top views along the axis of the sheath 2 of two examples of an inventive sealing element 1 like shown in figure 1. Herein, the mounting base 3 provides either the basic shape being a circle in figure 3 or the basic shape of a square in figure 4. The fastening element 10 of the mounting base 3 is located in the exterior part of said circle surrounding the sheath 2. The sheath 2 itself is located in the middle of the sealing element 1 and provides a passage 13 from one side of the mounting base 3 to the other. Like in figure 1 the fastening element 8 is a bulge located on the inside of the sheath 2.

Figure 5 shows a schematic cross section along the axis of the sheath 2 of another example of the inventive sealing element 1. Herein, the sidewalls of the sheath 2 are inclined to provide a narrow point 14 at the end of the sheath 2 on the exit side 17 of the mounting base 3. Next to the narrow point 14 on the inside of the sheath 2 the fastening element 8 of the sheath 2 is located. Such arrangement provides the benefit that when the pipe of the second device element is inserted the amount of force to forward the pipe increases based on the inclination. This results in a simplified and more secure fastening procedure, as the amount of force required to insert the pipe gives a feedback regarding its position to the user or machine used to insert said pipe. Furthermore, the narrow point 14 of the sheath 2 provides an additional seal for the sealing element 1 to prevent an undesired fluid or gas leakage.

Between the fastening element 8 of the sheath 2 and the connection point of the sheath 2 and the mounting base 3 the structural weakness 9 is located on the inside the sheath 2. On the right and left side of the mounting base 3 the fastening element 10 of the mounting base 3 is shown in the cross section of the figure surrounding the sheath 2. In this case the sheath 2 does not extend towards the entry side 16 of the mounting base 3.

Figure 6 shows a schematic cross section along the axis of the sheath 2 of another example of the inventive sealing element 1. Herein, the sheath 2 provides on the exit side 17 of the mounting base 3 no inclination as shown in figure 5, but a curvature also providing a narrow point 14. Furthermore, the ends of the sheath 2 representing the narrow point 14 are rounded.

Also located on the exit side 17 of the mounting base 3 the sheath 2 contains a fastening element 8 being a bulge to fasten the pipe of the second device element. On the outside of the sheath 2 a structural weakness 9 is visible being an indentation to provide an increased flexibility of the sheath 2 to adapt to the specific requirements. Based on the required flexibility and long term stability as well as lifetime, for example, the thickness of the sidewall of the indentation can be adapted. Also in this case the sheath 2 does not extend towards the entry side 16 of the mounting base.

The mounting base 3 is arranged essentially perpendicular to the sheath 2. In the exterior parts of the sheath 2 on the exit side of the mounting base 3 the mounting base 3 provides a fastening element 10 surrounding the sheath 2.

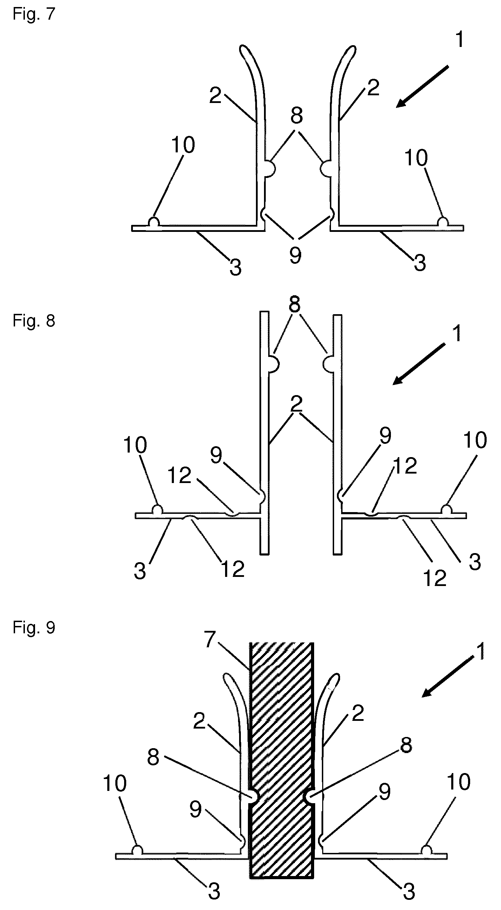

Figure 7 shows a schematic cross section along the axis of the sheath 2 of another example of the inventive sealing element 1. Herein, the sheath 2 also provides a curvature resulting, however, in a broadening of the end of the sheath 2. Such sheath 2 proved to be especially useful in case said broadened end represents the entry side of the pipe of the second device element. Such broadening additionally simplifies the insertion of the pipe of the second device element to compensate, for example, for a less exact handling or production fluctuations. Such broadened entry might further be more rigid than the rest of the sealing element 1 to provide, for example, an increased long term stability.

Below the broadened entry zone of the sheath 2 in figure 7 the fastening element 8 being a bulge is located on the inside of the sheath 2. Even further below the structural weakness 9 being an indentation is found on the inside of the sheath 2. The sheath 2 does not extend beyond the mounting base 3, wherein the mounting base 3 is attached perpendicular.

The fastening element 10 of the mounting base 3 is located in the exterior part of the mounting base 3 on the left and right side of the mounting base 3 of figure 7. Said fastening element 10 being a bulge is directed towards the side of the mounting base 3 providing the broadened entry of the sheath 2 and being beneficially used as entry side.

Figure 8 shows a schematic cross section along the axis of the sheath 2 of another example of the inventive sealing element 1. Herein, the shape of the sheath 2 is comparable to figure 1, wherein the sheath 2 provides a fastening element 8 being a bulge located on the inside of the sheath 2. Between the fastening element 8 of the sheath 2 and the connection point of the sheath 2 and the mounting base 3 a structural weakness 9 is located being an indentation on the outside of the sheath 2. The sheath 2 extends beyond the mounting base 3, however, the greater part of the sheath 2 is located on the side containing the fastening element 8 and the structural weakness 9 of the sheath 2.

The mounting base 3 of the inventive sealing element 1 according to figure 8 provides a fastening element 10 located at the end of the mounting base 3. Furthermore, the mounting base 3 provides two structural weaknesses 12 being indentations located on both surfaces of the mounting base 3. Introducing such structural weaknesses 12 into the mounting base 3 provides the benefit to further increase the flexibility of the sheath 2 to adapt to specific conditions.

Figure 9 shows a schematic cross section along the axis of the sheath 2 of another example of the inventive sealing element 1 and a pipe 7 of the second device element being attached thereto. Herein, the pipe 7 preferably enters the sheath 2 through the broadened entry of the sheath 2. Said broadened entry results from a curved form of a part of the sidewall of the sheath 2. The pipe 7 is reversibly fastened to the sheath 2 by means of a fastening element 8 being located between the broadened entry of the sheath 2 and the structural weakness 9 being an indentation located on the outside of the sheath 2. The mounting base 3 as shown in the example of figure 9 provides a fastening element 10 being located in the exterior part of the mounting base 3.

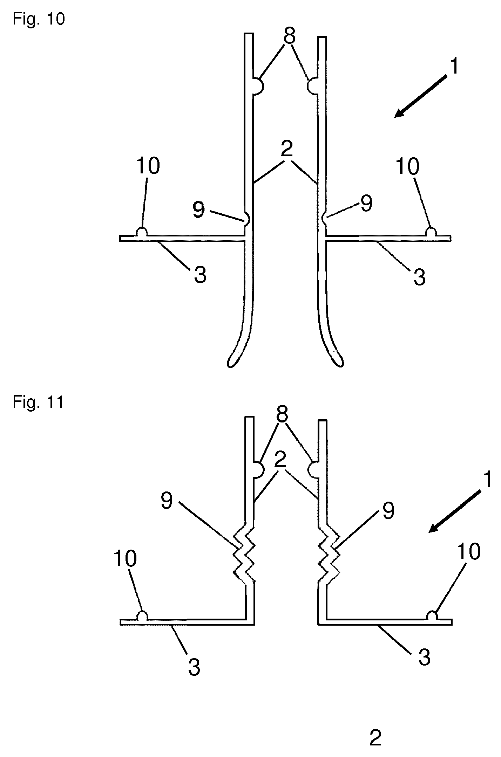

Figure 10 shows a schematic cross section along the axis of the sheath 2 of another example of the inventive sealing element 1. Herein, the structure is similar to the structure as shown in figure 1. However, the part of the sheath 2 opposite to the part containing the fastening element 8 and the structural weakness 9 is prolonged and provides a broadened entry. Said broadened entry results from the curved form of a part of the sidewall of the sheath 2. Such structure provides a more simplified insertion of the pipe of the second device element into the sheath 2, as the pipe is directed into the sheath 2 disregarding, for example, a slight misplacement of the first device element. Like in figure 1 the fastening element 10 of the mounting base 3 surrounds the sheath 2.

Figure 11 shows a schematic cross section along the axis of the sheath 2 of another example of the inventive sealing element 1. Herein, the structure is similar to the structure as shown in figure 1. However, the structural weakness 9 of the sheath 2 is an expansion joint providing the required flexibility of the movement of the sheath 2 to adapt to, for example, a minor incorrect orientation of the pipe of the second device element.

Furthermore, the sheath 2 provides fastening elements 8 on its inside, while the fastening element 10 of the mounting base 3 is located on the side of the mounting base 3 directed to the greater part of the sheath 2.

Figure 12 shows a schematic cross section along the axis of the sheath 2 of another example of the inventive sealing element 1 and a part of the first device element 4. The sealing element 1 itself is comparable to the sealing element 1 of figure 1, wherein the sheath 2, however, does not extend beyond the mounting base 3.

As shown in figure 12 the mounting base 3 is clamped between the parts of the first device element 4 to fasten the sealing element 1 in the opening of the first device element 4. Herein, the parts of the first device element 4 are adapted to receive the bulge of the mounting base 3 working as fastening element 10 of the mounting base 3. The parts of the first device element 4 can be, for example, screwed together to provide a reliable and long lasting connection securely fastening the sealing element 1.

The sheath 2 provides a fastening element 8 to reversibly fasten the pipe of the second device element. Furthermore, the sheath 2 provides the structural weakness 9 located on the outside of the sheath 2.

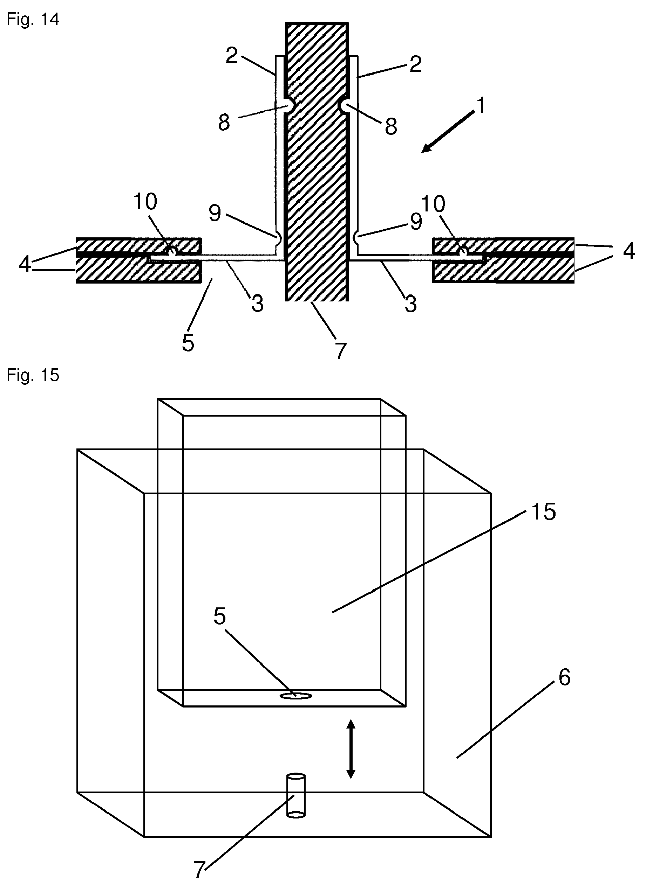

Figures 13 and 14 show schematic cross sections along the axis of the sheath 2 of another example of the inventive sealing element 1 and a part of the first device element 4, wherein the fastening element 10 of the mounting base 3 is firmly attached to the corresponding parts of the first device element 4. Figure 14 additionally contains a part of the pipe 7 of the second device element being reversibly fastened to the fastening element 8 located inside the sheath 2 providing structural weaknesses 9 on its outside to provide an increased flexibility. Contrary to the example shown in figure 12 the mounting base 3 provides a surface area not being in contact with the part of the first device element 4. Such structure provides a further increased flexibility of the movement of the sheath 2, as the mounting base 3 is able to more easily bend and twist. Furthermore, the opening 5 of the first device element 4 is increased allowing an easier insertion of the pipe 7 from below.

Such arrangement is especially preferred, if the inserted pipe 7 of the second device element ranges from one side of the mounting base 3 to the other. Figure 14 shows such case, wherein the pipe 7 is inserted and reaches beyond the connection point of the sheath 2 and the mounting base 3 and even through the complete sheath 2. For example, providing a sheath 2 extending beyond the mounting base 3 preferably including a broadened opening on the entry side of the mounting base 3 could be used to further simplify the insertion of the pipe 7. However, the arrangement of figures 13 and 14 also provide a highly efficient yet flexible structure additionally providing a reduction of the required overall size of the sealing element 1 and the first device element 4 containing said sealing element 1. For example, such reduction of the required overall size is especially important in sectors requiring high costs or providing problems, if additional space is claimed. Examples of such sectors are the clean room technology, aircraft technology and space craft technology.

Figure 15 shows a schematic structure of an example of the combination of a second device element 6 and a module 15 containing a first device element as used in an inventive treatment device. Module 15 is reversibly attached to the pipe 7 of the second device element 6 by pressing the opening 5 of the module 15 containing the sealing element against the pipe 7. Herein, the substrate to be treated can already be included in said module 15 or can be introduced into said module 15 later one. After the treatment of one or more substrates the module 15 is pulled out of the second device element 6 resulting in an automatic disconnection of the reversible fastening of the pipe 7. Such modular structure containing the inventive sealing element allows a more simplified and time efficient processing which can also be easily mechanized.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

### Reference Signs

- 1:: sealing element
- 2:: sheath
- 3:: mounting base
- 4:: first device element
- 5:: opening of the first device element (4)
- 6:: second device element
- 7:: pipe of the second device element (6)
- 8:: fastening element of the sheath (2)
- 9:: structural weakness of the sheath (2)
- 10:: fastening element of the mounting base (3)
- 11:: connection point of the sheath (2) and the mounting base (3)
- 12:: structural weakness of the mounting base (3)
- 13:: passage
- 14:: narrow point
- 15:: module
- 16:: entry side
- 17:: exit side

## Claims

1. A sealing element (1) containing a sheath (2) and a mounting base (3)adapted to connect a first device element (4) containing an opening (5) and a second device element (6) containing a pipe (7), wherein the orientation of the mounting base (3) is essentially perpendicular to the sheath (2),
wherein the sheath (2) contains at least one fastening element (8) on its inside,
wherein the mounting base (3) contains at least one fastening element (10), and
wherein the sheath (2) contains on its inside, its outside or both at least one structural weakness (9) located between the at least one fastening element (8) of the sheath (2) and a connection point (11) of the sheath (2) and the mounting base (3), the mounting base (3) contains at least one structural weakness (12) between the at least one fastening element (10) of the mounting base (3) and the connection point (11) of the sheath (2) and the mounting base (3), or both.

2. The sealing element (1) according to claim 1, wherein the at least one fastening element (10) of the mounting base (3) is a bulge of the mounting base (3), or
wherein the at least one fastening element (8) of the sheath (2) is a bulge on the inside of the sheath (2), or
wherein the at least one fastening element (10) of the mounting base (3) is a bulge of the mounting base (3), and the at least one fastening element (8) of the sheath (2) is a bulge on the inside of the sheath (2).

3. The sealing element (1) according to any of claims 1 to 2, wherein the at least one structural weakness (9) of the sheath (2) is an indentation or an expansion joint.

4. The sealing element (1) according to any of claims 1 to 3, wherein the sheath (2) provides at least one structural weakness (9) being an indentation,
wherein the at least one indentation is arranged between the connection point (11) of the sheath (2) and the mounting base (3) and at least one fastening element (8) of the sheath (2) adapted to fasten the pipe (7) of the second device element (6), and
wherein said indentation provides a minimal thickness of the sidewall being selected from the range from 0.2 to 0.7 of the average thickness of the sheath (2) next to the indentation.

5. The sealing element (1) according to any of claims 1 to 4, wherein the at least one fastening element (10) of the mounting base (3) is a squeeze-type fastening element (10).

6. The sealing element (1) according to any of claims 1 to 5, wherein the distance between the connection point (11) of the sheath (2) and the mounting base (3) and the first fastening element (10) of the mounting base (3) is at least 0.3 times the distance between the connection point (11) of the sheath (2) and the mounting base (3) and the first fastening element (8) of the sheath (2).

7. The sealing element (1) according to any of claims 1 to 6, wherein the distance between the connection point (11) of the sheath (2) and the mounting base (3) and the first fastening element (10) of the mounting base (3) is at most 2 times the distance between the connection point (11) of the sheath (2) and the mounting base (3) and the first fastening element (8) of the sheath (2).

8. The sealing element (1) according to any of claims 1 to 7, wherein the sealing element (1) provides an exit side (17) of the mounting base (3), and
wherein the sheath (2) provides a passage (13) containing at least one narrow point (14) at the exit side (17) of the mounting base (3).

9. The sealing element (1) according to any of claims 1 to 8, wherein the inside of the sheath (2) provides at least one element selected from the group consisting of curvatures, inclinations or combinations thereof, based upon a cross section along the axis of the sheath (2) and disregarding the at least one fastening element (8) and the at least one structural weakness (9).

10. A module containing a first device element (4) and a sealing element (1) according to any of claims 1 to 9,
wherein the mounting base (3) of the sealing element (1) is firmly attached to the first device element (4) by means of the at least one fastening element (10) of the mounting base (3).

11. The module according to claim 10, wherein the greater part of the sheath (2) of the sealing element (1) is located in the module.

12. A device containing a first device element (4) containing at least one opening (5), a second device element (6) containing at least one pipe (7) and at least one sealing element (1) according to any of claims 1 to 9,
wherein the mounting base (3) of the at least one sealing element (1) is firmly attached in the at least one opening (5) of the first device element (4) by means of the at least one fastening element (10) of the mounting base (3), and
wherein the at least one pipe (7) of the second device element (6) is adapted to be reversibly fastened to the sealing element (1) firmly attached in an opening (5) of the first device element (4) by means of the at least one fastening element (8) of the sheath (2) of the sealing element (1).

13. The device according to claim 12, wherein the first device element (4) and the sealing element (1) are part of a module according to any of claims 10 to 11 adapted to be reversibly connected to the second device element (6).

14. Method to reversibly and flexibly connect a first device element (4) containing at least one opening (5) and a second device element containing at least one pipe (7), wherein first a) the at least one sealing element (1) according to any of claims 1 to 9 is firmly attached to the first device element (4) by means of the at least one fastening element (10) of the mounting base (3), and
then b) the at least one pipe (7) of the second device element (6) is reversibly fastened to the at least one fastening element of the sheath (2) of the sealing element (1).

15. Use of the sealing element (1) according to any of claims 1 to 9 to provide a plug-and-use arrangement of a first device element (4) containing at least one opening (5) and a second device element (6) containing at least one pipe (7),
wherein the at least one sealing element (1) is firmly attached to the at least one opening (5) of the first device element (4) by means of the at least one fastening element (10) of the mounting base (3) to provide at least one fastening element (8) to reversible fasten at least one pipe (7) of a second device element (6) to the at least one fastening element (8) of the sheath (2) of the sealing element (1).
